# EUROPEAN PATENT APPLICATION

(11) **EP 1 148 558 A2**
(43) Date of publication of application: **24.10.2001**
(21) Application number: 00311104.4
(22) Date of filing: 13.12.2000
(51) Int. Cl.: H01L 31/0203

(54) **Image sensor integrated circuit package having cooling**

(30) Priority: 29.03.2000 US 538047
(71) Applicant: Omnivision Technologies Inc., Sunnyvale, California 94086 (US)
(72) Inventor: Foster, Ronald R., Los Gatos, California 95032 (US)
(74) Representative: Hackney, Nigel John

(57) **Abstract**

An apparatus that includes a CMOS image sensor secured to an active electronic cooling device integrated into a chip package. The active electronic cooling device may be a Peltier, Seebeck, Thompson or other physical effect device that causes heat to be transported by the flow of electric current.

## Description

The present invention relates to CMOS image sensors, and more particularly, to an integrated circuit package for a CMOS image sensor that provides cooling.

Integrated circuit technology has revolutionized various fields, including computers, control systems, telecommunications and imaging. In the field of imaging, the charge coupled device (CCD) sensor has made it possible to manufacture small hand held video cameras. Nevertheless, the solid state CCD integrated circuits needed for imaging are relatively difficult to manufacture, and therefore are expensive. In addition, because of the different processes involved in the manufacture of CCD integrated circuits relative to MOS integrated circuits, the signal processing portion of the imaging sensor has typically been located on a separate integrated chip. Thus, a CCD imaging device includes at least two integrated circuits: one for the CCD sensor, and one for the signal processing logic.

An alternative low cost technology to CCD integrated circuits is the metal oxide semiconductor (MOS) integrated circuit. Not only are imaging devices using MOS technology less expensive to manufacture relative to the CCD imaging device, but also for certain applications MOS devices are of superior performance. In addition, the signal processing circuitry can be integrated alongside the imaging circuitry, thus allowing for a single integrated chip to form a complete standalone imaging device.

Because of their low cost, MOS imaging devices are now used in many applications. Some of these applications are in high temperature environments, such as automotive applications. However, elevated temperatures cause the MOS image sensor to experience degradation in performance. Specifically, unwanted "dark current" increases proportionally to the operating temperature of the image sensor. The dark current limits the amplification that can be applied to the output signal of each pixel of the image sensor. This results in a diminished signal-to-noise ratio (SNR), rendering the device less sensitive to light than may be realized at lower operating temperatures.

Thus, what is needed is a method and apparatus for cooling the MOS image sensor, not only for high temperature applications, but also for improving image sensor performance in all environments.

An apparatus that includes a CMOS image sensor secured to an active electronic cooling device integrated into a chip package. The active electronic cooling device may be a Peltier, Seebeck, Thompson or other physical effect device that causes heat to be transported by the flow of electric current.

### Brief Description of the Drawings

The foregoing aspects and many of the attendant advantages of this invention will become more readily appreciated as the same becomes better understood by reference to the following detailed description, when taken in conjunction with the accompanying drawings, wherein:
FIGURE 1 is a top view of an integrated circuit package for a CMOS image sensor formed in accordance with the present invention;
FIGURE 2 is a side cross section view of the integrated circuit package of FIGURE 1 taken along line A-A'; and
FIGURE 3 is a side cross section view of an alternative embodiment of the integrated circuit package.

### Detailed Description of the Preferred Embodiment

The present invention discloses an imaging apparatus that includes a CMOS image sensor cooled by an active electronic cooling device integrated into a package. The active electronic cooling device may be a Peltier, Seebeck, Thompson or other physical effect device that causes heat to be transported by the flow of electric current.

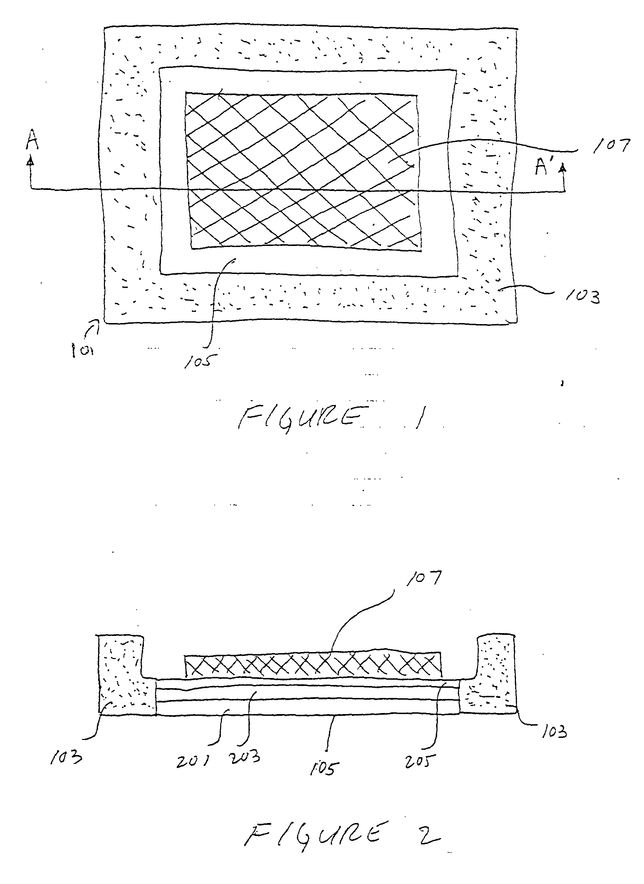

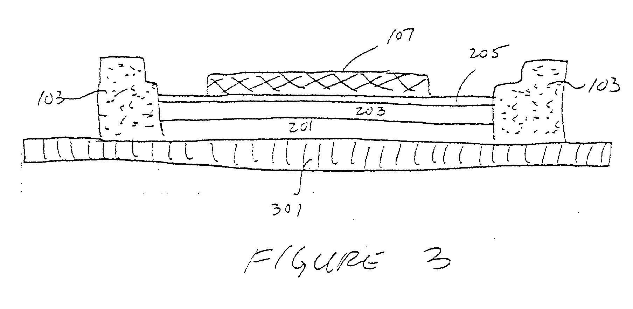

The preferred embodiment is shown in FIGURES 1 and 2. An imaging apparatus 101 includes an outer package 103, an electronic cooling device 105, and a CMOS image sensor 107. The CMOS image sensor 107 may be, for example, any of the CMOS image sensors manufactured and commercially sold by Omnivision Technologies, Inc. of Sunnyvale, CA. Preferably, the electronic cooling device 105 is a Peltier-type device. A Peltier device will transport heat from one side of the device, known as the cold side, to the other side of the device, known as the hot side, when a current is flowed through the device. Thus, as seen in FIGURE 2, the Peltier device 105 includes a hot side 201 and a cold side 203.

The Peltier device 105 is formed to be integral with the outer package 103, and indeed, is positioned such that the Peltier device 105 forms the bottom of the imaging apparatus 101. This can be done, for example, by removing the bottom of a conventional outer package 103 and replacing it with the Peltier device 105.

Preferably, the outer package 103 is formed from conventional semiconductor integrated circuit packaging material. For example, the outer package 103 may be formed from ceramic or epoxy plastic. The outer package 103 may also include electrical leads for communicating with an integrated circuit to be held by the package. The outer packages 103 may be obtained from any number of vendors.

Additionally, optionally placed between the cold side 203 and the CMOS image sensor 107 is a layer of electrical insulation 205. The electrical insulation 205 is necessary if, for example, the electrical polarity of the cold side of the Peltier junction does not have the same polarity as the substrate of the CMOS image sensor 107. Preferably, however, the CMOS image sensor 107 is placed directly onto the cold side 203 of the Peltier device 105.

By applying electric current to the Peltier device 105, heat is caused to be transported from the cold side 203 to the hot side 201. The heat generated by the CMOS image sensor 107 will be transported to the hot side 201 of the Peltier device 105. Thus, by placing the cold side 203 of the Peltier device 105 proximal to the CMOS image sensor 107, the CMOS image sensor 107 will be cooled. Further, optionally, the hot side 203 of the Peltier device 105 may be placed in contact or proximal with a heat sink. As seen in FIGURE 1, it is preferable that the hot side 201 of the Peltier device 105 be on the outside of the chip package.

Turning to FIGURE 3, optionally, a heat sink 301 can then be attached to the bottom of the chip package. In other words, the heat sink 301 is in contact with the hot side 201 of the Peltier device 105. The heat sink 301 acts to dissipate heat away from the hot side 201 of the Peltier device 105.

In the preferred embodiment, the cold side 201 of the Peltier device 105 is made to have the same electrical polarity as the substrate of the CMOS image sensor 107. However, if the cold side 201 of the Peltier device 105 does not have the same polarity as the substrate of the CMOS image sensor 107, an electrically insulating, but thermally conductive layer, such as aluminum oxide, should be added to separate the image sensor 107 and the Peltier device 105. This allows one of the electrical connections to the Peltier device 105 to be eliminated and the CMOS image sensor 107 is directly bonded to the cold side 203, thus maximizing the cooling effect of the device.

Similarly, in the preferred embodiment, the hot side 203 of the Peltier device 105 is made to have the same electrical polarity as the heat sink 301. This allows the other electrical connection to the Peltier device 105 to be eliminated and the heat sink 301 is directly bonded to the hot side 203, thus maximizing the cooling efficiency.

While the preferred embodiment of the invention has been illustrated and described, it will be appreciated that various changes can be made therein without departing from the spirit and the scope of the invention. The present invention has been described in relation to a preferred embodiment and several variations thereof. One of ordinary skill after reading the foregoing specification will be able to affect various changes, alterations, and substitutions of equivalents without departing from the broad concepts disclosed. It is therefore intended that the scope of the letters patent granted hereon be limited only by the definition contained in the appended claims and the equivalents thereof, and not by limitations of the embodiments described thereof.

The embodiments of the invention in which an exclusive property or privilege is claimed are defined as follows:

## Claims

1. An apparatus comprising:
(a) a CMOS image sensor formed on an integrated circuit; and
(b) a package structure for carrying said CMOS image sensor, said package structure including an active cooling device formed integral therewith.

2. The apparatus of Claim 1, wherein the active cooling device is a Peltier device that has a cold side and a hot side.

3. The apparatus of Claim 1, wherein the cold side of said Peltier device is in direct contact with said CMOS image sensor.

4. The apparatus of Claim 2, wherein an electrical insulator is placed between said Peltier device and said CMOS image sensor.

5. The apparatus of Claim 1, further including a heat sink in contact with said hot side of said Peltier device.

6. The apparatus of Claim 2, wherein the Peltier device forms a bottom side of said package structure.

7. The apparatus of Claim 1 wherein said CMOS image sensor has a substrate and said cold side of said Peltier device has the same electrical polarity as said substrate.

8. The apparatus of Claim 5 wherein said CMOS image sensor has a substrate and said hot side of said Peltier device has the same electrical polarity as said heat sink.

9. The apparatus of Claim 8 wherein said CMOS image sensor has a substrate and said cold side of said Peltier device has the same electrical polarity as said substrate.
